# EUROPEAN PATENT APPLICATION

(11) **EP 2 602 815 A1**
(43) Date of publication of application: **12.06.2013**
(21) Application number: 11814449.2
(22) Date of filing: 19.07.2011
(51) Int. Cl.: H01L 21/304, C11D 1/04, C11D 1/14, C11D 1/34, C11D 3/04, C11D 3/20, C11D 3/33

(54) **COMPOSITION FOR REMOVAL OF NICKEL-PLATINUM ALLOY METAL**

(30) Priority: 05.08.2010 JP 2010176134
(71) Applicant: SHOWA DENKO K.K., Tokyo 105-8518 (JP)
(72) Inventor: SATO, Fuyuki, Tokyo 105-8518 (JP); SAITO, Yasuo, Tokyo 105-8518 (JP)
(74) Representative: Strehl Schübel-Hopf & Partner
(86) International application number: PCT/JP2011/066377
(87) International publication number: WO 2012/017819

(57) **Abstract**

A composition for the removal of nickel-platinum alloy metal, said composition being characterised by including 3-55 mass% of at least one kind selected from the group consisting of hydrochloric acid, hydrobromic acid, and nitric acid, 0.5-20 mass% of a chelating agent other than oxalic acid, 0.1-4 mass% of an anionic surfactant, and water; and also characterised by not including fluorine-containing compounds or hydrogen peroxide, and having a pH of 1 or less. Nickel-platinum alloy metal can be selectively removed without damaging silicon substrate material.

## Description

### Technical Field

The present invention relates to a composition for removal of nickel-platinum alloy-based metals. More particularly, the invention relates to a composition for removal of metals that can selectively remove nickel-platinum alloy-based metals without affecting silicon-based materials.

### Background Art

Electrodes such as gates, sources and drains are silicidated to reduce contact resistance in semiconductor devices, in order to achieve greater micronization, power saving and speed increase for MOS type transistors. The metals used in electrodes of the prior art include silicides of nickel, cobalt, titanium and tungsten. In recent years, in order to further reduce contact resistance of electrodes and control heat resistance and overgrowth, alloys comprising nickel with addition of platinum at a few atomic percent, for example, have been used to form nickel-platinum silicides.

When nickel silicides containing no platinum have been used in the past, a nickel thin-film is formed on a polysilicon surface and nickel silicide is formed in a self-aligning manner by heat treatment, (salicide process), and then treated with SPM (sulfuric acid/hydrogen peroxide mixture) or HPM (hydrochloric acid/hydrogen peroxide mixture), commonly employed for RCA cleaning, to remove the excess nickel.

However, such a method is inadequate for producing devices using nickel-platinum silicide. Platinum is a metal with very powerful corrosion resistance, and when treated with chemical solutions commonly used for removal of nickel and the like, or with SPM or HPM, a problem results as residue consisting mainly of platinum remains on the surface of the semiconductor device substrate. Such residue leads to problems with the electrical characteristics, reliability and yields for semiconductor devices.

Also, when treatment is carried out using etching solutions with powerful dissolving ability for removal of platinum residue, such as aqua regia, the surface tends to become roughened and variable in thickness, which has adverse effects on the properties of the semiconductor device.

Research has therefore been conducted on methods for selectively removing nickel-platinum without damaging silicides. Patent Document 1 discloses a method in which most of the nickel is first removed by SPM, and then in order to protect the nickel-platinum silicide, it is treated with a chemical comprising a substance with a property of coordinating with nickel, such as a water-soluble solution comprising ammonia water or cyanide, after which the platinum is removed by dissolution with aqua regia. Handling of materials in this method is difficult, however, due to the use of aqua regalis which has powerful corrosive power, or toxic cyanide.

Also, Patent Document 2 discloses a cleaning method in which nickel and platinum are removed by treatment at a high temperature near 71°C to 150°C using SPM, HPM or APM (ammonia/hydrogen peroxide mixture), while avoiding damage to nickel-platinum silicide. In this method, however, the solution also lacks stability because it contains hydrogen peroxide among its components, and thus produces foaming during solution preparation and during heating.

In addition, PTL 3 discloses a method of removing excess nickel from nickel silicide-formed sections, by adding an organic acid to a water-soluble solution containing chloride ion. A typical example of such a composition is one comprising oxalic acid, hydrochloric acid, hydrogen peroxide and fluoroboric acid. In Patent Document 3, however, the object is removal of only nickel thin-films that contain no platinum, while nothing is mentioned regarding the ability to remove nickel-platinum alloys. Furthermore, an oxidizing agent and a fluorine-containing compound are essentially added to the composition. Fluorine-containing compounds can potentially etch SiO₂, while hydrogen peroxide lacks stability, and therefore difficulties exist in their application to production of semiconductor devices using silicon-based substrate materials.

### Prior Art References

### Patent Documents

[Patent Document 1] Japanese Unexamined Patent Publication No. 2009-176818
[Patent Document 2] Japanese Unexamined Patent Publication No. 2008-118088
[Patent Document 3] Japanese Patent Public Inspection No. 2008-547202

### Summary of the Invention

### Problems to be Solved by the Invention

The present invention has been devised to solve the problems mentioned above, and its object is to provide a composition for removal of metals that can selectively remove nickel-platinum alloy-based metals without damaging silicon-based substrate materials. Means for Solving the Problems

As a result of diligent research on compositions for removal of metals having functions of removing nickel-platinum alloys without affecting silicon-based materials, the present inventors have found that it is possible to selectively remove nickel-platinum alloys without damaging silicon-based materials such as nickel silicide, Si, Si₃N₄ or SiO₂, by using an aqueous composition with a pH of ≤ 1, comprising an acid, a chelating agent and an anionic surfactant, and comprising no fluorine-containing compound or hydrogen peroxide, and the invention has been completed upon this finding. Specifically, the invention comprises the following aspects.

[1] A composition for removal of nickel-platinum alloy-based metals, comprising at least one compound selected from the group consisting of hydrochloric acid, hydrobromic acid and nitric acid at 3 to 55 mass%, a chelating agent other than oxalic acid at 0.5 to 20 mass%, an anionic surfactant at 0.1 to 4 mass% and water, while comprising no fluorine-containing compound or hydrogen peroxide, and having a pH of not greater than 1.
[2] The composition for removal of nickel-platinum alloy-based metals according to [1], which consists of at least one compound selected from the group consisting of hydrochloric acid, hydrobromic acid and nitric acid, a chelating agent other than oxalic acid, an anionic surfactant and water.
[3] The composition for removal of nickel-platinum alloy-based metals according to [1] or [2], wherein the chelating agent is at least one selected from the group consisting of citric acid, ethylenediaminetetraacetic acid, catechol, acetylacetone and their salts.
[4] The composition for removal of nickel-platinum alloy-based metals according to any one of [1] to [3], wherein the anionic surfactant is at least one selected from the group consisting of sulfuric acid esters, sulfonic acids, carboxylic acids and phosphoric acid esters, each having C8-20 straight-chain alkyl groups, and their derivatives and salts.
[5] The composition for removal of nickel-platinum alloy-based metals according to any one of [1] to [4], wherein the nickel-platinum alloy-based metal contains nickel at 85-99.5 atomic percent and platinum at 0.5-15 atomic percent.
[6] The composition for removal of nickel-platinum alloy-based metals according to any one of [1] to [5], which does not erode silicon, SiO₂, Si₃N₄ or nickel silicide.
[7] The composition for removal of nickel-platinum alloy-based metals according to any one of [1] to [6], which removes nickel-platinum alloy-based metal formed on a portion of a substrate made of a silicon-based material.
[8] A method for producing a semiconductor device, comprising a step of forming a nickel-platinum alloy film on a portion of a substrate made of a silicon-based material, and a step of selectively removing at least a portion of the nickel-platinum alloy film using the composition for removal of nickel-platinum alloy-based metals according to any one of [1] to [7], without damaging the silicon-based material.
[9] The method for producing a semiconductor device according to [8], wherein the silicon-based material is silicon, SiO₂, Si₃N₄ or nickel silicide.
[10] A method for producing a semiconductor device, comprising a step of forming polysilicon and nickel-platinum alloy thin-films in that order as electrode materials on at least a portion of a substrate made of a silicon-based material, a step of forming a nickel-platinum silicide in a self-aligning manner by heat treatment, and a step of selectively removing the unreacted nickel-platinum alloy using the composition for removal of nickel-platinum alloy-based metals according to any one of [1] to [7].

### Effect of the Invention

The composition for removal of metals according to the invention is capable of selective removal of nickel-platinum alloys without damaging silicon-based materials, and is highly effective for production of semiconductor devices such as MOS-type transistors.

### Brief Description of the Drawings

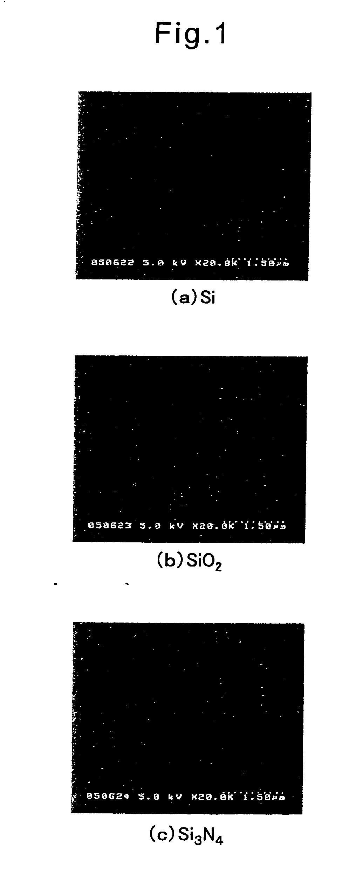

Fig. 1 is a set of plan views of SEM images showing the surfaces of a silicon substrate, a SiO₂ film-formed silicon substrate and a Si₃N₄ film-formed silicon substrate, respectively, after treatment at 50°C for 30 minutes using a composition of Example 1 of the invention.

### Modes for Carrying Out the Invention

Preferred embodiments of the invention will now be explained in detail.

The composition for removal of nickel-platinum alloy-based metals according to the invention is an acidic solution comprising at least one compound selected from the group consisting of hydrochloric acid, hydrobromic acid and nitric acid, a chelating agent other than oxalic acid, an anionic surfactant and water, while comprising no fluorine-containing compound or hydrogen peroxide, and it has the property of selectively removing nickel-platinum alloy-based metals from silicon-based materials.

The composition for removal of nickel-platinum alloy-based metals according to the invention dissolves mainly nickel in nickel-platinum alloys by acid, and prevents re-attachment of metal components onto semiconductor wafer surfaces by a chelating agent effect. Furthermore, since it does not contain unstable components such as hydrogen peroxide, it can be used and stored in a stable manner. In addition, because it does not contain fluorine-containing compounds, it produces little damage to silicon-based materials such as Si, SiO₂, Si₃N₄ and silicides. Furthermore, for platinum atoms dissociated from the nickel-platinum alloy and dispersed, or for aggregates composed mainly of platinum, the surfaces of the platinum atoms or the aggregates are modified by coordination or electrostatic adsorption of chelating agents and anionic surfactants, thereby inhibiting adhesion onto semiconductor wafer surfaces. By using such a composition for removal of metals it is possible to provide an effective means for semiconductor device-forming methods that employ the salicide process. In addition, with optimization, the composition for removal of nickel-platinum alloy-based metals according to the invention can be used for treatment to convert substrate surfaces to a condition with very low residue of nickel and platinum.

The acid used in the composition for removal of nickel-platinum alloy-based metals according to the invention includes one or more from among hydrochloric acid, hydrobromic acid and nitric acid, but it is preferably hydrochloric acid or nitric acid, because high-purity products suitable for semiconductor fabrication steps are readily available and inexpensive. The acid is added to the composition for removal of metals at preferably 3 to 55 mass% and more preferably 3 to 48 mass%. If the acid concentration is lower than 3 mass%, the concentration of components contributing to metal removal will be low, making it impossible to efficiently remove metals. Furthermore, there is no significant improvement in removal ability even if the acid concentration is higher than 55 mass%. Other acids may also be used, so long as the concentrations of hydrochloric acid, hydrobromic acid and nitric acid are within the aforementioned concentration range. The method of adding the acid may be directly as the acid, but it may also be generated in the solution by addition of any desired acid and the salt with the anion of the acid to be added. For example, the scope of the invention includes mixing of sulfuric acid, which has poor etching ability for nickel, with ammonium chloride which has a common anion with hydrochloric acid, generating hydrochloric acid as a result, as well as mixing of acetic acid and ammonium bromide which has a common anion with hydrobromic acid, generating hydrobromic acid as a result, because the same performance is exhibited. Combinations of a plurality of the aforementioned acids may also be added.

The chelating agent is used for scavenging by the chelating effect of the dissolved metal ion, and to prevent adhesion on the board surface by modification on the aggregate surfaces of the non-dissolving metals, and to protect the silicon-based material. Specific examples of chelating agents include ethylenediaminetetraacetic acid (EDTA), catechol, citric acid, acetylacetone, iminodiacetic acid, nitrilotriacetic acid (NTA), ethylenediamine, hexamethylenediaminetetraacetic acid, diethylenetriaminepentaacetic acid (DTPA), 1,2-diaminocyclohexanetetraacetic acid (CyDTA), bis(2-aminoethyl)ethyleneglycol tetraacetic acid (EGTA), bis(2-hydroxyethyl)glycine, ethylenediaminedipropionic acid, thiourea, urea, quinoline, ammonia, thiocyanic acid, cyanic acid, pyrogallol, resorcinol, acetic acid, propionic acid, butyric acid, formic acid, lactic acid, ascorbic acid, tartaric acid, succinic acid, malonic acid, malic acid, maleic acid, glutamic acid, 1-hydroxyethylidene-1,1-diphosphonic acid, creatine, creatinine, sulfamic acid, biuret, ethanolamine, dimethylglyoxime, dithizone, thioacetic acid, thiomalic acid, cysteine, glycine, alanine, cyclodextrin, and derivatives of the foregoing. Of these, ethylenediaminetetraacetic acid (EDTA), catechol, citric acid and acetylacetone are preferred, with citric acid being even more preferred for use from the viewpoint of safety for the environment. These chelating agents may also be added in the form of salts. From the viewpoint of usage in a semiconductor device, an ammonium salt or tetramethylammonium salt is preferred. The addition concentration of the chelating agent cannot be specified for all cases since it will differ depending on the chemical species, but it is preferably 0.5 to 20 mass% and more preferably 2 to 10 mass%. If the chelating agent addition concentration is lower than 0.5 mass%, it will not be possible to satisfactorily remove nickel and non-dissolving metals. The addition concentration is also preferably not greater than 20 mass%, because there will be no significant difference in the removal performance and sufficient dissolution may not be possible depending on the type of chelating agent, while it may lead to precipitate in the solution or residue on the electronic device substrate. Oxalic acid is preferably not used as the chelating agent because its removal performance for nickel is inferior.

An anionic surfactant is used to remove metal and other residue, and to protect the silicon-based material. The type of anionic surfactant may be a) a sulfuric acid ester, b) sulfonic acid, c) a carboxylic acid, d) a phosphoric acid ester, having a C8-20 straight-chain alkyl group, or a derivative of a)-d) or a salt of a)-d). More specifically, examples with C12 straight-chain alkyl groups include ammonium dodecyl sulfate, triethanolamine dodecyl sulfate, dodecylbenzenesulfonic acid, dodecylsulfonic acid and dodecyldiphenyl ether disulfonic acid, with no particular restrictions on the type so long as it is an anionic surfactant. These anionic surfactants may also be added in the form of salts. The addition concentration cannot be specified for all cases since it will differ depending on the compound, but it is preferably 0.1-4 mass% and more preferably 0.4-4 mass%. If the addition concentration of the surfactant is lower than 0.1 mass%, it may not be possible to sufficiently remove the nickel-platinum alloy. While the surfactant may be used at an addition concentration of higher than 4 mass%, there is no significant improvement in the removal effect. There may also be added simultaneously therewith a nonionic surfactant such as a polyoxyalkylenealkyl ether derivative, which exhibits an antifoaming effect.

The composition for removal of metals according to the invention will usually be used as a water-soluble solution, but if necessary an organic solvent that mixes with water, such as acetonitrile, acetone, methanol, ethanol or isopropanol, may also be added. The organic solvent is not particularly limited so long as it does not affect the removal performance. Also, treatment with the composition for removal of metals according to the invention may be followed by after-cleaning with such organic solvents, to remove residue of the chelating agent from the substrate.

The term "nickel-platinum alloy-based metal", for the purpose of the invention, is an alloy composed mainly of nickel and platinum, and typically it refers to an alloy comprising 85-99.5 atomic percent nickel and 0.5-15 atomic percent platinum. Also included among the metals that may be treated by the composition for removal of metals according to the invention, are those that comprise a metal other than platinum, for example, a precious metal such as gold, palladium, iridium, ruthenium or rhodium, a corrosion-resistant metal such as tantalum or hafnium, or another common metal, as well as a nitride or oxide of these metals, and unavoidable impurity components whose inclusion is impossible to avoid during processing, refining and film formation of metals, as a portion of the platinum content of the alloy, in the range specified above.

The composition for removal of nickel-platinum alloy-based metals according to the invention can be used to remove a nickel-platinum alloy-based metal film formed on a substrate. The composition for removal of nickel-platinum alloy-based metals according to the invention does not affect silicon-based materials such as silicon, SiO₂, Si₃N₄ or nickel silicide, and it can therefore be suitably used for removal of nickel-platinum alloy-based metal films formed on substrates made of these silicon-based materials. There are no particular restrictions on the method of forming the nickel-platinum alloy-based metal film on the substrate, and any method such as sputtering, CVD (Chemical Vapor Deposition), ALD (Atomic Layer Deposition), vacuum vapor deposition or plating may be employed, also with no limitations on the film-forming conditions or heat treatment conditions.

Among silicon-based materials on which the nickel-platinum alloy-based metal is to be formed, which is to be treated using a composition for removal of nickel-platinum alloy-based metals according to the invention, silicon, SiO₂ or Si₃N₄ may be mixed with germanium, or doped with boron, nitrogen, phosphorus, arsenic, gallium, antimony or the like. Also, nickel silicides typically include nickel silicide and nickel-platinum silicide (silicides of nickel and nickel-platinum), and because these undergo altered composition and distribution of atoms on the semiconductor device surface by heat treatment during production of the semiconductor device, they are also included among silicon-based materials to be treated with a composition for removal of metals according to the invention.

When a semiconductor device is to be produced using a composition for removal of nickel-platinum alloy-based metals according to the invention, treatment may be performed several times to an extent that does not damage the silicon-based substrate material, with after-cleaning using ultrapure water or the like, to further improve the removal performance. In the examples and comparative examples of the invention, the metal-removal property was judged based on 1.0 × 10¹⁴ atoms/cm², but when even stricter removal performance is required depending on the semiconductor device, the treatment time or treatment temperature may be extended to a degree that does not damage the silicon-based material.

The amount of liquid volume used for the composition for removal of nickel-platinum alloy-based metals according to the invention, as well as the number of treatments and the treatment temperature, may be set as desired to optimize selectivity and removing ability, according to the metal thin-film forming conditions and the film thickness. Treatment is carried out with a liquid temperature of preferably 1°C to 100°C and more preferably 15°C to 80°C, to obtain excellent metal removing ability, metal selectivity and usable life of the solution. When used at a lower temperature, the metal removing ability may be reduced and precipitate of the components may occur. When it is to be used at a higher temperature, warming may be carried out while considering the variation in the concentration due to component decomposition and volatilization of the solution components.

Since the composition for removal of nickel-platinum alloy-based metals according to the invention contains no fluorine-containing compounds, it can avoid damaging silicon-based materials such as nickel silicide, Si, SiO₂ or Si₃N₄ while selectively removing nickel-platinum alloys from substrates made of such materials.

When a semiconductor device is to be manufactured using a composition for removal of nickel-platinum alloy-based metals according to the invention, usually a step is carried out in which a semiconductor wafer is dipped in the composition for removal of nickel-platinum alloy-based metals by a batch method. Treatment may also be carried out by supplying the composition for removal of metals to the surface of the semiconductor wafer using a single wafer method. Such treatment may be carried out while agitating, rocking or applying ultrasonic waves. The electronic device used may be one other than a MOS-type transistor, so long as it is a device that has a nickel-platinum alloy as a constituent material.

The composition for removal of nickel-platinum alloy-based metals according to the invention may be used with the aforementioned composition for production of an actual semiconductor device, but from the viewpoint of facilitating transport and precipitation, it may instead be produced, transported and stored as a solution with an increased concentration, having equivalent proportions of each of the components other than water. Such a solution is diluted with ultrapure water for use in the concentration range specified according to the invention.

One example of producing a semiconductor device using a composition for removal of nickel-platinum alloy-based metals according to the invention includes the following steps. Specifically, it is a production method comprising a step of forming a nickel-platinum alloy film on at least a portion of the silicon-based substrate, and a step of selectively removing at least a portion of the nickel-platinum alloy film using the composition for removal of metals according to the invention, without damaging the silicon-based substrate. The method may be applied, for example, in a step of forming a thin-film of polysilicon and nickel-platinum alloy as the electrode materials sequentially, forming nickel-platinum silicide in a self-aligning manner by heat treatment, and removing the unreacted nickel-platinum alloy using the composition for removal of metals according to the invention (salicide-forming step).

### Examples

The present invention will now be explained in greater detail by examples and comparative examples, with the understanding that the invention is in no way limited thereto.

### (Evaluation of removing ability for nickel and platinum)

The following procedure was carried out to evaluate the removing effect on nickel and platinum, when a nickel-platinum alloy film-attached substrate was dipped in a composition for removal of metals. A thin-film comprising an alloy composed of 90 atomic percent nickel and 10 atomic percent platinum was formed on a silicon substrate by sputtering. The film thickness was 15 nm. The substrate was cut into a 2 × 1 cm rectangle to obtain a sample piece for evaluation of the metal-removing ability. The composition for removal of metals was prepared by adding each of the components to water with the compositions of the examples and comparative examples listed in Tables 1 to 3, and 10 mL of each prepared composition was loaded into a polyethylene container. The sample piece was placed in the container, left still, and kept warm for 30 minutes at 50°C. The sample piece was then removed from the container and ultrapure water was used for cleaning of the entire sample piece. The ultrapure water was produced using a Milli-Q Water producer (Millipore, electric conductivity: 18.2 MΩ). The acids used were 35 mass% hydrochloric acid, 98 mass% sulfuric acid and 60 mass% nitric acid (all by Kishida Chemical Co., Ltd., for electronic material use) and 48 mass% hydrobromic acid (Wako Pure Chemical Industries, Ltd., special grade), the chelating agents used were a 50 mass% citric acid aqueous solution (Komatsuya Co., Ltd., high-purity product), oxalic acid dihydrate and ethylenediaminetetraacetic acid (both products of Kishida Chemical Co., Ltd.), the anionic surfactants used were a 40 mass% triethanolamine dodecyl sulfate aqueous solution (product of Wako Pure Chemical Industries, Ltd., hereunder abbreviated as "dodecylsulfuric acid salt") and 90 mass% dodecylbenzenesulfonic acid (product of Kanto Kagaku Co., Ltd.), and the other reagent used was 30 mass% hydrogen peroxide water (product of Kishida Chemical Co., Ltd., for electronic material use). The HPM used in Table 3 was a mixture of 35 mass% hydrochloric acid:30 mass% hydrogen peroxide water = 1:1, the SPM used was 97 mass% sulfuric acid:30 mass% hydrogen peroxide water = 1:1, and the aqua regia was 35 mass% hydrochloric acid:60 mass% nitric acid = 3:1 (all volume ratios). The mixing procedure for the preparation was irrespective of the properties of the solution to be obtained. The water in the composition for removal of metals consists of ultrapure water and the water in the reagents.

Next, each of the sample pieces treated with a composition for removal of metals having a different composition was used for recovery of the residual metal on the sample piece surface using a metal-recovering solution comprising aqua regia and hydrofluoric acid, and was analyzed with an ICP mass spectrometer. The following metal-recovering solution was dropped 4 times at 0.25 mL each time in a uniform manner only on the front side of the sample piece which had the metal thin-film, and after standing for approximately 3 minutes, the entire recovering solution was collected. The metal-recovering solution used was prepared at the time of use, by mixing aqua regia:hydrofluoric acid:ultrapure water in a ratio of = 1:1:4 (volume ratio). When a metal-recovering solution is dropped onto a sample piece, the hydrofluoric acid component etches not only the metal components but also the oxides on the silicon surface, and since the sample piece surface becomes hydrophobic so that the droplets are repelled from the surface, part of the interior is dissolved together with the sample piece surface layer, and the metal components can be recovered. In addition, by dissolving the platinum with the aqua regia component, it is possible to efficiently recover the metal components remaining on the sample piece surface. The aqua regia used was a mixture of 60 mass% nitric acid (product of Kanto Kagaku Co., Ltd., Ultrapur grade) and 35 mass% hydrochloric acid (product of Kanto Kagaku Co., Ltd., Ultrapur grade) in a ratio of nitric acid:hydrochloric acid = 1:3. The hydrofluoric acid used was 38 mass% hydrofluoric acid (product of Kanto Kagaku Co., Ltd., Ultrapur grade). Next, a micropipette was used to transfer the metal-recovering solution to a TEFLON^{R} container, and the metal-recovering solution was heated to 200°C for evaporation to dryness. Aqua regia (1+19) was added to the TEFLON^{R} container for redissolution, obtaining a constant volume of 2 ml. The Ni and Pt concentrations of the measuring solution were analyzed using an ICP mass spectrometer (product of Seiko Instruments, Inc., SPQ-8000H), and the number of metal atoms remaining on the sample piece was calculated. The metal removing ability was evaluated from the obtained value. The results are shown in Tables 1 to 3, as the numbers of residual Ni and Pt atoms (atoms/cm²). The TEFLON^{R} containers and micropipette tips used were all pre-washed with dilute aqua regia and ultrapure water to prevent contamination.

### (Evaluation of silicon-based material damage)

First, a nickel silicide film-attached substrate was dipped in the composition for removal of the metals, and the extent of damage was evaluated by the following procedure. A thin-film composed of nickel silicide (NiSi₂) was formed on the silicon substrate by sputtering. A film with a thickness of 50 nm was used. The substrate was cut into a 2 × 0.5 cm rectangle and the sheet resistance value before treatment was measured with a sheet resistance meter. Next, a composition for removal of metals according to the invention was used for treatment similar to that conducted for evaluation of the nickel and platinum removing ability, and the substrate was naturally dried. The sheet resistance value was again measured after treatment, and minute variations in film thickness were evaluated. When the film thickness decreases, the amount of current that can flow through the film also decreases, thereby increasing the sheet resistance value. The sheet resistance value was evaluated by measurement five times with a four-point probe low resistance meter, taking the average values as values before and after treatment, and determining the difference between the measured values before and after treatment. The results are shown in Table 3. Next, the presence of residue of silicon, SiO₂ and Si₃N₄ and any damage were evaluated. For silicon, there was used a silicon wafer by itself, and for SiO₂ and Si₃N₄, there was used a substrate with a film formed to a thickness of 50 nm on a silicon wafer by sputtering. The treatment was carried out using the composition of Example 1 in Table 1, which is a representative composition for removal of metals according to the invention, at 50°C for 30 minutes, and rinsing with ultrapure water was followed by natural drying. The treated substrate was evaluated with an interferometric film thickness tester (VM-2000, product of Dainippon Screen Mfg. Co., Ltd.) to evaluate the variation in SiO₂ and Si₃N₄ film thickness. The surface form and residue were also evaluated by SEM (S-5000 by Hitachi, Ltd.). Observation by SEM was conducted with an acceleration voltage of 5 kV and a magnification of 20, 000x. The results are shown in Fig. 1.

[Table 1]

**Table 1**

| Composition (Content: mass% conc.) | | | | | | | Removing ability (atoms/cm²) | |
|---|---|---|---|---|---|---|---|---|
| | Component 1 | Content | Component 2 | Content | Component 3 | Content | Ni | Pt |
| Example 1 | HCl | 28 | Citric acid | 10 | DSTEA | 0.4 | 4.1E+13 | 1.6E+13 |
| Example 2 | HCl | 14 | Citric acid | 5 | DSTEA | 0.3 | 2.5E+13 | 3.2E+12 |
| Example 3 | HCl | 3 | Citric acid | 10 | DSTEA | 0.4 | 3.1E+13 | 3.9E+12 |
| Example 4 | HCl | 28 | Citric acid | 20 | DSTEA | 0.4 | 5.0E+13 | 5.8E+12 |
| Example 5 | HCl | 28 | Citric acid | 2 | DSTEA | 0.4 | 8.1E+13 | 7.4E+13 |
| Example 6 | HCl | 28 | Citric acid | 0.5 | DSTEA | 0.4 | 6.9E+13 | 4.5E+13 |
| Example 7 | HCl | 28 | Citric acid | 10 | DSTEA | 0.1 | 6.9E+13 | 4.5E+13 |
| Example 8 | HCl | 25 | Citric acid | 9 | DSTEA | 3.6 | 1.7E+13 | 6.2E+12 |
| Example 9 | HBr | 38 | Citric acid | 10 | DSTEA | 0.4 | 7.7E+13 | 1.4E+13 |
| Example 10 | HNO₃ | 55 | Citric acid | 10 | DSTEA | 0.4 | 3.9E+13 | 2.4E+13 |
| Example 11 | HCl | 28 | EDTA | 5 | DSTEA | 0.4 | 7.6E+13 | 4.9E+12 |
| Example 12 | HCl | 28 | Acetylacetone | 10 | DSTEA | 0.4 | 3.7E+13 | 6.5E+12 |
| Example 13 | HCl | 28 | Catechol | 10 | DSTEA | 0.4 | 3.2E+13 | 4.7E+12 |
| Example 14 | HCl | 28 | Citric acid | 10 | DDBSA | 0.4 | 6.0E+13 | 4.2E+13 |
| ·DSTEA: Triethanolamine dodecyl sulfate, DDBSA: Dodecylbenzenesulfonic acid, EDTA: Ethylenediamine tetraacetic acid | | | | | | | | |

| | | | | | | | | |
|---|---|---|---|---|---|---|---|---|
| ·DSTEA: Triethanolamine dodecyl sulfate, DDBSA: Dodecylbenzenesulfonic acid, EDTA: Ethylenediamine tetraacetic acid | | | | | | | | |

[Table 2]

**Table 2**

| Composition (Content: mass% conc.) | | | | | | | Removing ability (atoms/cm²) | |
|---|---|---|---|---|---|---|---|---|
| | Component 1 | Content | Component 2 | Content | Component 3 | Content | Ni | Pt |
| Comp. Ex. 1 | HCl | 28 | Citric acid | 10 | | | 1.9E+14 | 1.5E+14 |
| Comp. Ex. 2 | HCl | 28 | Citric acid | 10 | DSTEA | 0.08 | 1.4E+14 | 1.6E+14 |
| Comp. Ex. 3 | HCl | 28 | | | DSTEA | 0.4 | 1.0E+14 | 5.2E+13 |
| Comp. Ex. 4 | HCl | 28 | | | | | 3.5E+14 | 5.9E+13 |
| Comp. Ex. 5 | | | Citric acid | 10 | | | >1.0E+15 | >1.0E+15 |
| Comp. Ex. 6 | | | | | DSTEA | 0.4 | >1.0E+15 | >1.0E+15 |
| Comp. Ex. 7 | HCl | 28 | Oxalic acid | 7 | DSTEA | 0.4 | 1.1E+14 | 1.0E+14 |
| ·DSTEA: Triethanolamine | | | | | | | | |

| | | | | | | | | |
|---|---|---|---|---|---|---|---|---|
| ·DSTEA: Triethanolamine dodecyl sulfate | | | | | | | | |

[Table 3]

**Table 3**

| | Composition | Removing ability (atoms/cm²) | | Difference in sheet resistance value before and after treatment (Ω/sq.) |
|---|---|---|---|---|
| | | Ni | Pt | NiSi₂ |
| Example 1 | 28%HCl-10%Citric acid-0.4%DSTEA | 4.1E+13 | 1.6E+13 | 0 |
| Comp. Ex. 4 | 28%HCl | 3.5E+14 | 5.9E+13 | +0.4 |
| Comp. Ex. 8 | Aqua regalis | 3.3E+13 | 6.8E+12 | +1.6 |
| Comp. Ex. 9 | HPM | 3.8E+13 | 2.3E+13 | +1.2 |
| Comp. Ex. 10 | SPM | 1.1E+14 | 2.4E+14 | 0 |

| | | | | |
|---|---|---|---|---|
| ·DSTEA: Triethanolamine dodecyl sulfate | | | | |

Tables 1 and 2 show the summarized evaluation results for nickel and platinum removal ability when nickel-platinum alloy film-attached substrates were dipped in compositions for removal of metals. All of the compositions for removal of nickel-platinum alloy-based metals according to the invention, in Examples 1 to 14, were capable of removing nickel and platinum to concentrations of below 1.0 × 10¹⁴ atoms/cm² on substrate surfaces. However, in Comparative Examples 1 to 6 which either did not contain an acid, chelating agent or anionic surfactant or had their concentrations outside of the specified ranges, and in Comparative Example 7 which included oxalic acid as a chelating agent, the nickel or platinum residue density on the substrate surface was 1.0 × 10¹⁴ atoms/cm² or greater, indicating that they had inferior removing ability for nickel-platinum alloys compared to the compositions of the examples. The component dissolving the metal is presumably the acid, but since it is widely known that platinum cannot be dissolved with hydrochloric acid alone, it is believed that the composition for removal of metals according to the invention dissolves and removes primarily the nickel components from the substrate with the acid component, and prevents re-attachment of the metal components and complex-formed chelating agent onto the substrate, with the chelating agent and anionic surfactant. A similar effect was obtained when the acid was changed to hydrobromic acid or nitric acid (Examples 9 and 10, respectively), when the chelating agent was changed to ethylenediaminetetraacetic acid, acetylacetone or catechol (Examples 11 to 13, respectively), and when the surfactant was changed to dodecylbenzenesulfonic acid (Example 14). When the chelating agent was oxalic acid (Comparative Example 7), satisfactory removing ability could not be exhibited. All of the compositions of Examples 1 to 14 had pH values of not higher than 1. The pH was measured at 25°C with a pH meter (F-52, product of Horiba, Ltd.).

Table 3 shows the evaluation results for damage to the nickel silicide films. When a composition for removal of metals according to the invention (composition of Example 1) was used, excellent removing ability was exhibited for nickel and platinum, and no damage was incurred on the nickel silicide. When aqua regia or HPM was used, however, while excellent removing power was exhibited for nickel and platinum, damage was simultaneously incurred on the nickel silicide. When SPM was used, no damage was incurred on the nickel silicide, but the removing ability for nickel and platinum was poor. With hydrochloric acid alone, the metal removing ability was unsatisfactory and damage was also incurred on the nickel silicide.

Fig. 1 shows SEM images of substrate surfaces, for a silicon substrate, a SiO₂ film-attached silicon substrate and a Si₃N₄ film-attached silicon substrate, that have been treated with a composition for removal of metals having the composition of Example 1. None of the silicon-based material substrates exhibited changes in the surface shape before and after treatment with the metal removing solution, nor had any visible adhesion of residue. The same result was seen even with increased magnification (to 100,000x, for example). Also, measurement with an interferometric film thickness tester showed that none of the surfaces had variation in film thickness before and after treatment. Thus, a composition for removal of nickel-platinum alloy-based metals according to the invention can selectively remove nickel and platinum from substrates made of silicon-based materials (Si, SiO₂ and Si₃N₄), without incurring damage.

### Industrial Applicability

The composition for removal of nickel-platinum alloy-based metals according to the invention is useful for production of semiconductor devices, since it can efficiently remove nickel-platinum alloys without affecting substrates made of silicon-based materials.

## Claims

1. A composition for removal of nickel-platinum alloy-based metals, comprising at least one compound selected from the group consisting of hydrochloric acid, hydrobromic acid and nitric acid at 3 to 55 mass%, a chelating agent other than oxalic acid at 0.5 to 20 mass%, an anionic surfactant at 0.1 to 4 mass% and water, while comprising no fluorine-containing compound or hydrogen peroxide, and having a pH of not greater than 1.

2. The composition for removal of nickel-platinum alloy-based metals according to claim 1, which consists of at least one compound selected from the group consisting of hydrochloric acid, hydrobromic acid and nitric acid, a chelating agent other than oxalic acid, an anionic surfactant and water.

3. The composition for removal of nickel-platinum alloy-based metals according to claim 1 or 2, wherein the chelating agent is at least one selected from the group consisting of citric acid, ethylenediaminetetraacetic acid, catechol, acetylacetone and their salts.

4. The composition for removal of nickel-platinum alloy-based metals according to any one of claims 1 to 3, wherein the anionic surfactant is at least one selected from the group consisting of sulfuric acid esters, sulfonic acids, carboxylic acids and phosphoric acid esters, each having C8-20 straight-chain alkyl groups, and their derivatives and salts.

5. The composition for removal of nickel-platinum alloy-based metals according to any one of claims 1 to 4, wherein the nickel-platinum alloy-based metal contains nickel at 85 to 99.5 atomic percent and platinum at 0.5 to 15 atomic percent.

6. The composition for removal of nickel-platinum alloy-based metals according to any one of claims 1 to 5, which does not erode silicon, SiO₂, Si₃N₄ or nickel silicide.

7. The composition for removal of nickel-platinum alloy-based metals according to any one of claims 1 to 6, which removes nickel-platinum alloy-based metal formed on a portion of a substrate made of a silicon-based material.

8. A method for producing a semiconductor device, comprising a step of forming a nickel-platinum alloy film on a portion of a substrate made of a silicon-based material, and a step of selectively removing at least a portion of the nickel-platinum alloy film using the composition for removal of nickel-platinum alloy-based metals according to any one of claims 1 to 7, without damaging the silicon-based material.

9. The method for producing a semiconductor device according to claim 8, wherein the silicon-based material is silicon, SiO₂, Si₃N₄ or nickel silicide.

10. A method for producing a semiconductor device, comprising a step of forming polysilicon and nickel-platinum alloy thin-films in that order as electrode materials on at least a portion of a substrate made of a silicon-based material, a step of forming a nickel-platinum silicide in a self-aligning manner by heat treatment, and a step of selectively removing the unreacted nickel-platinum alloy using the composition for removal of nickel-platinum alloy-based metals according to any one of claims 1 to 7.
